Europäisches Patentamt

European Patent Office

Office européen des brevets

(11) Publication number: **0 112 416**
**A1**

## EUROPEAN PATENT APPLICATION

(21) Application number: **82306865.5**

(22) Date of filing: **22.12.82**

(51) Int. Cl.³: **G 09 G 1/04, H 03 K 4/02**

(43) Date of publication of application: **04.07.84**
Bulletin 84/27

(84) Designated Contracting States: **DE FR GB IT**

(71) Applicant: **International Business Machines Corporation, Old Orchard Road, Armonk, N.Y. 10504 (US)**

(72) Inventor: **Ainscow, Frank, Cobb House Southdown Road, Shawford Hampshire (GB)**

(74) Representative: **Blake, John, IBM United Kingdom Patent Operations Hursley Park, Winchester, Hants, S021 2JN (GB)**

(54) **Vertical timebase circuit for cathode ray tube.**

(57) The field timebase circuit of a CRT includes a staircase generator for producing a stepped current waveform. The generator is synchronised with the horizontal synchronisation pulse, the vertical deflection field stepping only in response to the stepped waveform. The vertical or field synchronisation pulse is used to reset the staircase generator. In practice a capacitor 31 is periodically charged in synchronisation with the horizontal flyback pulse by means of a charge generator 30. A buffer amplifier 32 and power amplifier 33 connected to the capacitor 31 provide the vertical or field deflection current. Reset circuit 36 responsive to the vertical or field synchronisation pulse periodically discharges the capacitor 31 to a base value.

0112416

## VERTICAL TIMEBASE CIRCUIT FOR CATHODE RAY TUBE

This invention relates to a vertical timebase circuit for a raster-scanned cathode ray tube.

As is well known, a raster-scanned cathode ray tube employs deflection coils to which currents are supplied to cause the electron beam to scan across the screen in a raster pattern, normally as a series of horizontal scans from top to bottom. Typically, for example as described in US Patent 3,476,973, ramp circuits are provided which produce sawtooth-shaped waveforms which drive the electron beam across and down the screen. The field or vertical timebase circuit operates at a lower frequency than the line or horizontal timebase circuit, typically two hundred and fifty to one thousand times slower.

The CRT raster may be non-interlaced or interlaced where two or more fields are interlaced to produce each frame. Interlacing is used to reduce flicker.

When a CRT display employs voltage ramps to raster-scan the screen, problems will arise when it is desired to vary the display format. A circuit for changing the display format of a CRT is described in US Patent 4,230,974 in which a logic unit will respond to a format change signal to short out portions of the horizontal deflection yoke. By thus changing the number of winding turns the magnetic field is varied to vary the CRT line width. A vertical sawtooth oscillator is synchronized to the vertical synchronization signal, the amplitude (and hence the picture height) being varied by the logic unit in accordance with the format change signal.

An object of the present invention is to provide an improved vertical (field) deflection circuit in which the top margin of the display, skip and interlace can be accurately set.

According to the present invention, cathode ray tube apparatus comprises a cathode ray tube having a screen, line scanning means for causing one or more electron beams to scan a line across the screen, field scanning means for causing the or each electron beam to move across the screen in a direction substantially orthogonal to the line scan direction, and line and field synchronization means for causing the or each electron beam to scan across the screen in a raster, and is characterised in that said field scanning means comprises a stepping circuit for causing a stepped current waveform to be supplied to field scanning coils with each step in the waveform being synchronized with the line flyback whereby movement of the or each beam in the direction orthogonal to the line scan direction occurs only in response to the steps.

In order that the invention and its advantages may be more readily understood, an embodiment will now be described with reference to the accompanying drawings, in which:-

Figure 1 is a schematic of a CRT vertical deflection ciruit employing principles in accordance with the present invention;

Figure 2 shows waveforms of the known ramp (sawtooth) circuits and the waveform produced by the circuit of Figure 1;

Figures 3 to 6 show some of the problems encountered with the known ramp circuit arrangements and how these problems are mitigated using the present invention;

Figure 7 is a block diagram of a preferred embodiment of the invention; and

Figure 8 is a circuit diagram showing how the preferred embodiment might be fabricated.

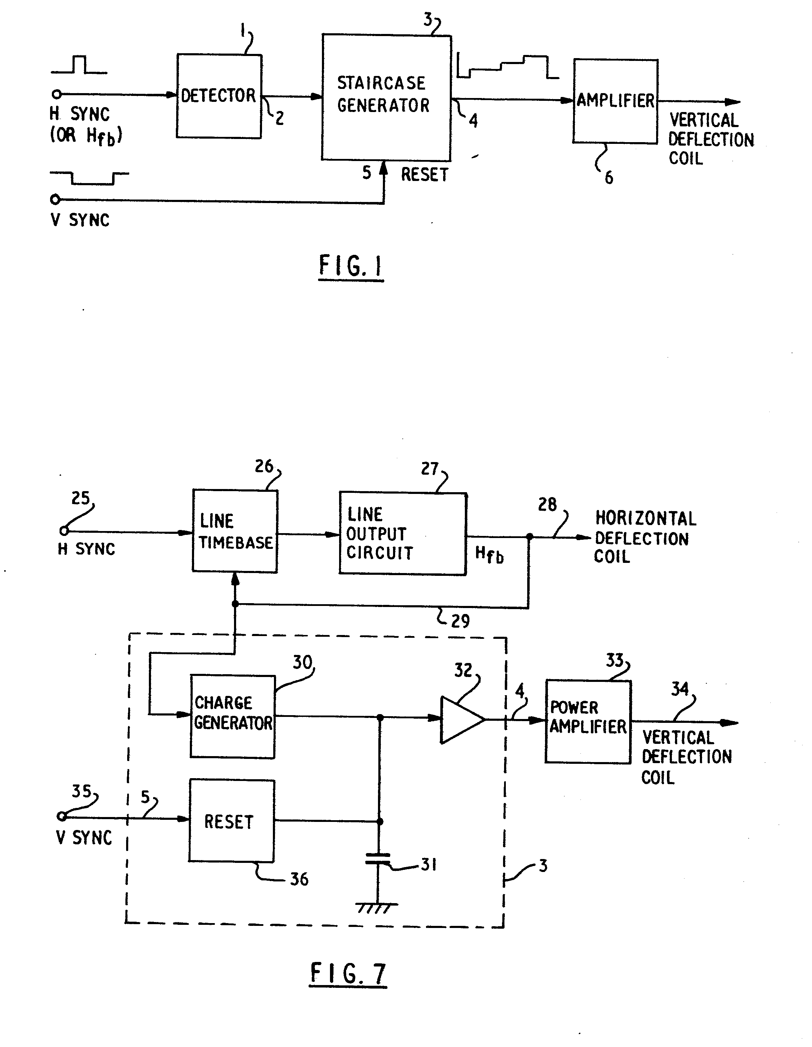

Referring now to Figure 1, horizontal synchronization pulses (H. sync) are detected in a detector 1 whose output 2 is connected to a staircase current generator 3. The output 4 of the staircase generator 2 provides a series of stepped levels, the level being stepped upon each detection of the H. sync pulse. At the end of each field, the vertical synchronization (V. sync) pulse applied to reset input 5 of the staircase generator 3 causes the latter to reset. An amplifier 6 amplifies the stepped waveform from the output 4 and applies a corresponding current to the vertical deflection coil (not shown) of the cathode ray tube (not shown).

Although the detector 1 is shown in Figure 1 as being responsive to the H. sync pulse, it could as an alternative be responsive to any pulse which depends on the H. sync pulse, for example the horizontal flyback pulse $(H_{fb})$.

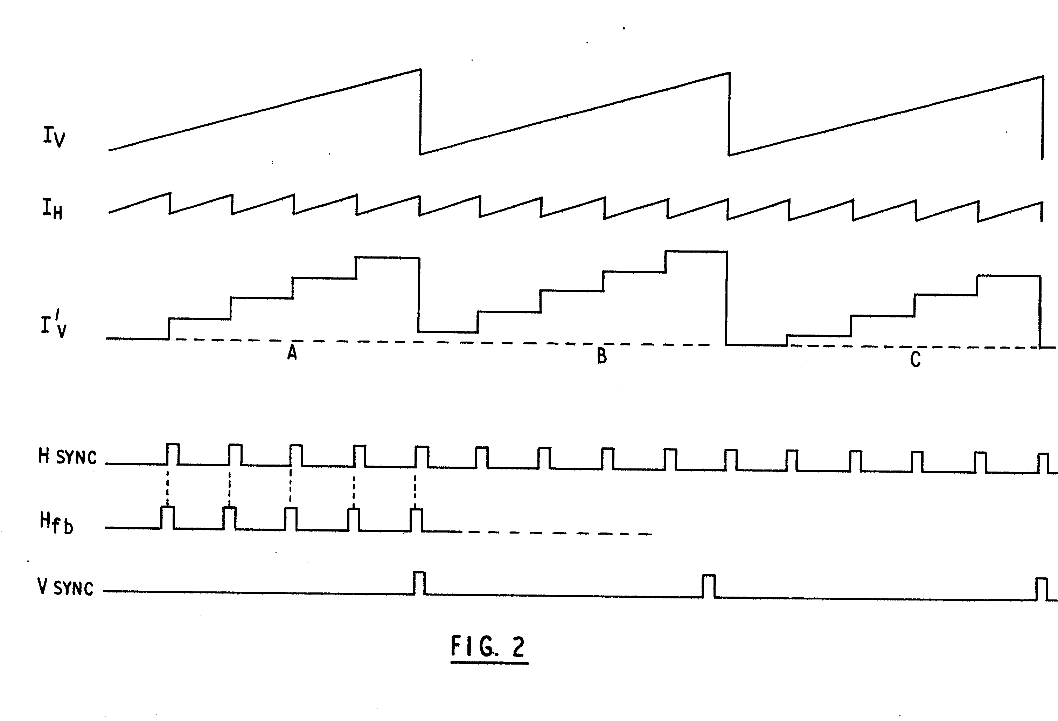

Figure 2 is a waveform diagram showing the various waveforms which occur in a raster-scanned cathode ray tube. The ramp-shaped vertical current waveform $I_V$, ramp-shaped horizontal current waveform $I_H$, horizontal flyback pulse waveform $H_{fb}$ and vertical synchronization waveform V. sync are conventional and need not be further described. However in contrast to the prior art, the vertical current waveform $I_V'$ used in the present invention is not ramp-shaped but is a stepped waveform as shown. This has a number of significant advantages.

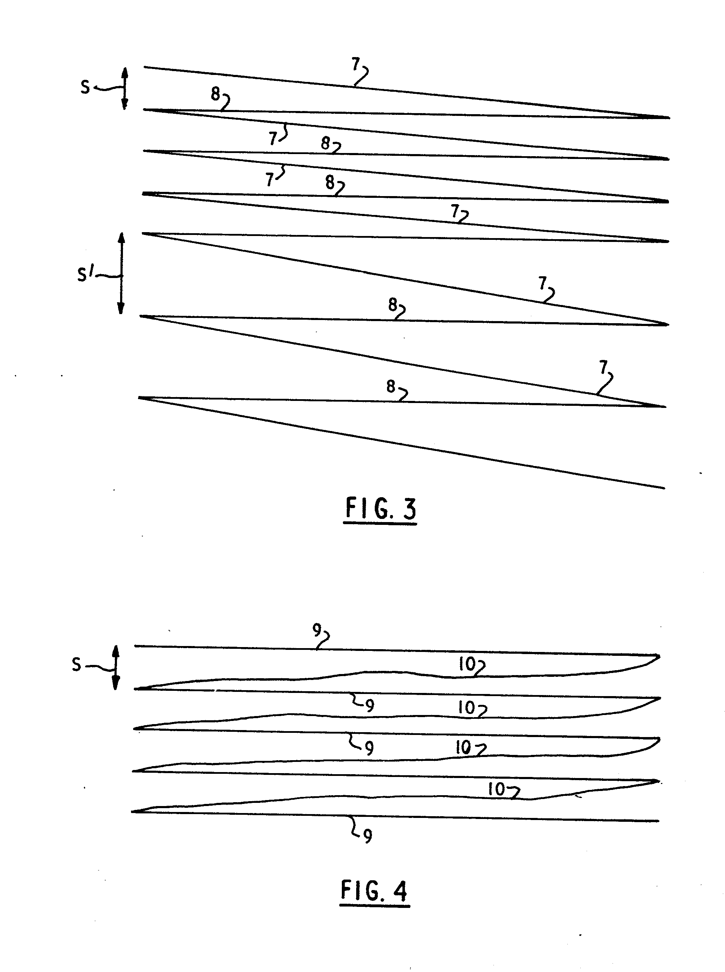

Figure 3 shows the shaped of the path traced by an electron beam on the cathode ray tube screen when using a ramp-shaped vertical deflection current. Downwardly inclined lines 7 represent the so-called "horizontal" scan lines whilst horizontal lines 8 represent the path of the beam during each line flyback period. In fact because the ramp-shaped vertical current $I_V$ is increasing during the line flyback period, path 8 would be sloped slightly downwards right to left. However since the flyback period is very much smaller than the line scan period, the vertical movement of the beam during line flyback can be ignored for present purposes.

It will be apparent that the amount of vertical movement of the beam is essentially dependent upon the time it takes the beam to traverse the screen during the line scan. Thus if, for any reason, the frequency of the horizontal synchronization were to vary, so too would the spacing between the scan lines. This is represented by the spacings S and S' in Figure 3.

In contrast, with the stepped vertical current waveform $I_V'$ synchronized with the horizontal synchronization (or line flyback) there is no variation in the interline spacing S as is shown in Figure 4. As will be seen in Figure 4, because of the synchronization vertical movement of the beam due to the steps in the waveform occurs only during line flyback. During the line scan itself there is no vertical movement of the beam as represented by horizontal lines 9. During line flyback, the current $I_V'$ will step to the next value. By this means it can be ensured that th eline scan starts at the desired vertical positions of the scan line. Clearly if it is desired to "skip" a scan line, the step in the current waveform can be made correspondingly large. Vertical movement, as represented by lines 10, occurs entirely during the line flyback period when, of course, the beam is blanked.

The use of a stepped vertical deflection waveform has significant advantages in an interlaced cathode ray tube display. Commonly each frame will consist of two interlaced fields but in theory 3:1 or generally n:1 interlace is possible. The present invention will be described with reference to a 2:1 interlace but it will be appreciated that the principles may be applied to n:1 interlace generally.

0112416

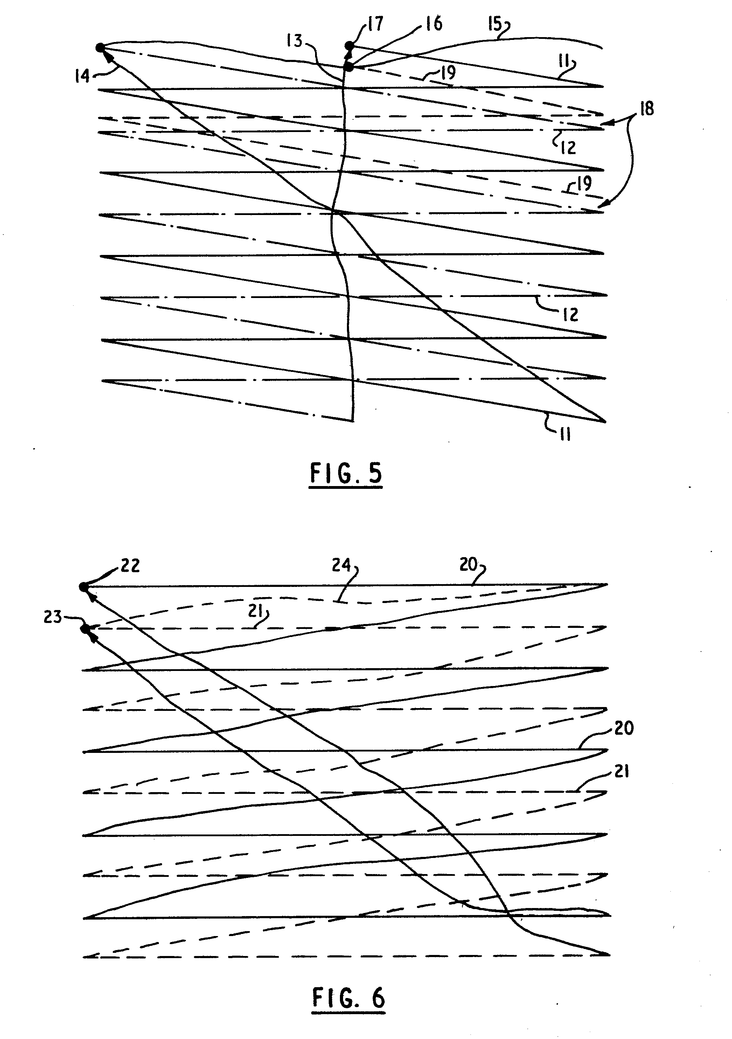

Figure 5 represents a 2:1 interlaced raster in which the odd field is represented by solid line 11 and the even field is represented by dot/dashed line 12. Lines 13 and 14 represent the path of the beam during field flyback during which the beam will be blanked. In practice, of course, each field will consist of a very much larger number of scan lines. Also shown in Figure 5 is a problem which can be encountered with such an interlaced system employing current ramps. Line 15 in Figure 5 represents horizontal scan-induced noise. In such circumstances, the actual start position for the odd fields will be at point 16 rather than the normal starting position 17. The scan lines will thus be lower on the screen than they should be giving rise to "line pairing" as at 18 where the displaced scan in the odd field, represented by dashed line 19, closes up on the scan in the even field.

Figure 6 represents the odd and even fields 20 and 21 in which the odd fields have a starting position 22 and the even fields have a starting position 23. This is accomplished by resetting the staircase generator 3, Figure 1, to an initial value which depends on whether it is an odd or even field. This is represented by parts A and B of waveform $I_V'$ in Figure 2: the step increments will be constant in each field. In an alternative arrangement represented by parts A and C of waveform $I_V'$ in Figure 2, it is arranged that the staircase generator is reset to the same value after each field so that both odd and even fields start from the same position 22: in this case, however, it is arranged that for the even fields, only a half-step increment is added to the current waveform at the end of the first scan line (represented by line flyback 24) so that the second scan line of the even field starts from position 23. Although the first scan lines of the odd and even fields coincide in the screen, it can be ensured that this is not viewed by the viewer, either by arranging it outside the visible area or by blanking the beam during the first scan line of the even field.

The use of a stepping circuit driven from the line scan of the cathode ray tube and used to control the vertical deflection gives high linearity, since the size of each step can be precisely controlled, and gives a vertical deflection whose amplitude will not vary with line frequency (H. sync or $H_{fb}$) giving constant raster line spacing even if the line scan is irregular.

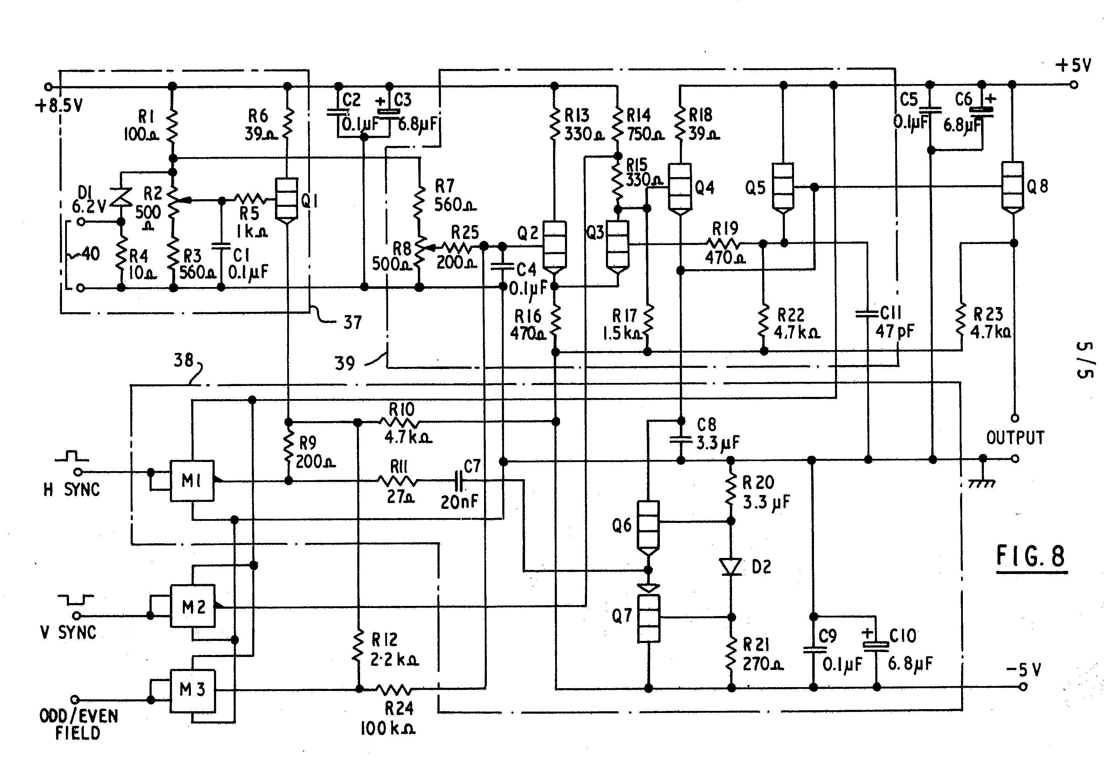

Figure 7 is a block diagram of a preferred embodiment of the inventinon in which the line flyback pulse $H_{fb}$ is used to step the staircase generator. In Figure 7, H. sync pulses at input 25 are received by conventional line timebase circuit 26 connected to line output circuit 27. In conventional manner the line output circuit 27 supplies the line flyback pulse $H_{fb}$ to the horizontal deflection coil (not shown) of the cathode ray tube along line 28. Feedback is provided, in conventional manner between the output of circuit 27 and the line timebase circuit 26, along line 29 to ensure correct synchronization.

Also connected to receive the line flyback pulses $H_{fb}$ is a charge generator 30 which supplies a controlled charge to capacitor 31 at the start of each flyback pulse. The resulting potential on the capacitor 31 is applied to the input of buffer amplifier 32 and thence to power amplifier 33 which drives a corresponding current in the vertical deflection coil (not shown) of the cathode ray tube along line 34. When vertical synchronization signals V. sync applied at terminal 35 are detected in reset circuit 36, the capacitor is discharged to reset the generator. The next horizontal flyback pulse $H_{fb}$ will begin re-charging of the capacitor 31.

Figure 8 is a circuit diagram of a practical embodiment of the present invention. It is desirable to implement the circuit of Figure 8 as an integrated circuit. However it would also be possible to construct the circuit with readily available components. Typical values for the various resistors and capacitors are shown. Logic blocks M1, M2 and M3 are inverters which can be formed from one quarter of the integrated circuit SN 7401 (open collector NAND gates) obtainable from Texas Instruments Inc and other semiconductor manufacturers.  PNP
transistor Q7 can be the commonly available type 2N2907, NPN transistors
Q1, Q2, Q3, Q5, Q6 and Q8 can be the commonly available type 2N2222 and
the NPN transistor Q4 can be type BC337.

The circuit within block 37 determines the spacing between scan
lines, adjustment of the variable resistor R2 varying the scan lien
spacing and hence the picture height.  Circuit 38 is a so-called "cup
and bucket" circuit in which charge stored in capacitor C7 (having a
value dependent on the setting of variable resistor R5 in circuit 37) is
transferred upon each H. sync pulse received by logic block M1 to
capacitor C8.  The accumulated charge on capacitor C8 will determine the
voltage appearing on the emitter of buffer transistor Q8.  Circuit 39 is
a reset circuit which upon detection of a V. sync pulse at logic block
M2 will discharge the capacitor C8 to a base value (determined by the
setting of R8) corresponding to the current value for the beam to scan
along the first row.

Logic block M3 detects a signal indicative of whether an odd or
even field is being displaced.  If it is the latter, a voltage
equivalent to half a step size is added to the reference voltage to
which C8 is reset so that the even field is shifted bodily by half a
line spacing with respect to the odd field.  In a variation, the
"half-step charge" could be injected into C8 by another "cup" circuit
during the first scan line of the even field.

Typically the H. sync pulse is a positive-going pulse of width
10 μsec and frequency 20 kHz approximately.  Typically the V. sync pulse
is a negative-going pulse of 500 μsec width and frequency 90 Hz
approximately with a constant phase relationship with the H. sync pulse.
The odd/even field signal could be a square wave which changes state on
each negative-going edge of the V. sync signal.

A more detailed operation of the circuit of Figure 8 is as follows.

In the "cup and bucket" circuit 38, capacitor C8 is progressively charged in a negative direction by the injection of small amounts of charge, defined by capacitor C7 and the voltage change across it, in response to horizontal synchronization pulses. This gives excellent linearity and immunity to timing jitter on the synchronization lines.

Zener diode D1 provides voltage reference for the whole circuit. The resistor/transistor combination controls the amplitude of the voltage pulses applied to capacitor C7, and hence the overall size of the output waveform (picture height control). The size of the interlace displacement is controlled simultaneously. Resistor R8 sets the start voltage of the waveform, (top margin control). Resistor R4 allows a small amount of simultaneous modulation of both parameters, should this be needed for EHT tracking. For test purposes, resistor R4 is shorted as at 40.

H. sync pulses are received by open-collector TTL blcok M1. The output down level is fixed; the up level is set by the transistor Q1 emitter. This controlled voltage swing is applied to one terminal of capacitor C7. The other terminal of capacitor C7 is constrained by transistors Q6 and Q7 to change in potential by approximately 0.65 volts. Consequently, a fixed amount of charge is passed back and forth through capacitor C7 on each cycle of H. sync. On positive edges, this charge is dumped via transistor Q7 into the -5v rail; on negative edges, the charge is passed through transistor Q6 into capacitor C8, charging it in a negative direction by a fixed amount.

During the field scan, the V. sync input is at TTL up-level, so M2 output is negative. The potentiometer chain R15, R17 translates that voltage to a lower one which ensures that transistor Q4 is cut off. This allows capacitor C8 to charge under the influence of transistor Q6 etc. At the leading edge of the V. sync pulse, M2 output goes open circuit. This allows transistor Q4 base to go positive and charge capacitor C8. Charging continues until the voltage on capacitor C8, as monitored by transistor Q5, rises to a level set by resistor R8.  At
this point transistors Q2, Q3, Q4 and Q5 form an operational amplifier
which accurately stabilises the voltage on capacitor C8.

At the end of the V. sync pulse, control of capacitor C8 is
released, and the charging cycle restarts on the next H. sync pulse.
Transistor Q8 is an output buffer to minimise the loading on capacitor
C8 by the output current.  It is separate from transistor Q5 to
eliminate coupling of the V. sync trailing edge to the output.

TTL block M3 receives the odd/even field signal from the logic and
inverts it.  The pulse amplitude at the output is made to track with the
picture height setting in order to ensure accurate interlace at all
control settings.

What has been described is a cathode ray tube apparatus using a
stepped vertical deflection waveform synchronized with the horizontal
synchronization pulses.  It will be evident that although horizontal
scan lines have been described, the inventinon is equally applicable to
rasters having vertical scans.  Equally whilst the invention has been
described in terms of 2:1 interlace, other forms of interlace can be
employed.  The invention is applicable to cathode ray tubes which have
more than one electron beam, for example colour cathode ray tubes.

CLAIMS

1.    Cathode ray tube apparatus comprising a cathode ray tube having a screen, line scanning means for causing one or more electron beams to scan a line across the screen, field scanning means for causing the or each electron beam to move across the screen in a direction substantially orthogonal to the line scan direction, and line and field synchronization means for causing the or each electron beam to scan across the screen in a raster, characterised in that said field scanning means comprises a stepping circuit for causing a stepped current waveform to be supplied to field scanning coils with each step in the waveform being synchronized with the line flyback whereby movement of the or each beam in the direction orthogonal to the line scan direction occurs only in response to the steps.

2.    Apparatus as claimed in claim 1 adapted to produce an $n$ to 1 interlaced raster, further including field flyback means operable at the end of the $m$th field in a frame to return the or each electron beam to a starting position spaced $(m - 1)$ $n$ths of the spacing between line scans in a field from the starting position of the first field in the frame.

3.    Apparatus as claimed in claim 1 adapted to produce an $n$ to 1 interlaced raster, in which field flyback means is operable to return the or each electron beam to a fixed starting position for each field and in which the current waveform is stepped during the first line of the mth field by an amount equivalent to $(m-1)$ $n$ths of the spacing between scan lines in a field.

4.    Apparatus as claimed in any preceding claim comprising means for varying the size of the displayed picture by varying the sizes of the steps in the stepped current waveform and hence the spacing between the scan lines.

5.    Apparatus as claimed in any preceding claim in which said stepped current waveform is derived from charge storage means whose charge is varied in synchronism with the line synchronization pulse.

6.    Apparatus as claimed in claim 5, further including means responsive to a field synchronization pulse to discharge said charge storage means to a base value.

7.    Apparatus as claimed in claim 6 comprising means for supplying charge equivalent to a fraction of the spacing between adjacent scan line in a field to said charge storage means and operable on sequential fields thereby to produce an interlaced raster.

FIG. 1

FIG. 7

FIG. 2

0112416

FIG. 3

FIG. 4

FIG. 5

FIG. 6

FIG.8

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-3 422 363 (R.H. FOOTE et al.)<br>* Whole document * | 1,5,6 | G 09 G 1/04<br>H 03 K 4/02 |
| Y | | 2 | |
| Y | ELECTRONICS, vol. 43, no. 22, October 26, 1970, pages 91-97, New York, US<br>W.R. SPOFFORD JR.: "Putting d-a converters to work: 10 examples show versatility" * Page 94, left-hand column, lines 1-20 * | 2 | |
| A | IBM TECHNICAL DISCLOSURE BULLETIN, vol. 9, no. 4, September 1966, pages 376-377, Yorktown Heights,US<br>H.A. FERRIER et al.: "Sweep circuitry for cathode ray tube display" * Entirely * | 1 | TECHNICAL FIELDS SEARCHED (Int. Cl. ³)<br><br>H 03 K<br>G 09 G |

The present search report has been drawn up for all claims

| Place of search | Date of completion of the search | Examiner |
|---|---|---|
| THE HAGUE | 29-08-1983 | GYSEN L.A.D. |